# EUROPÄISCHE PATENTSCHRIFT

(11) **EP 0 429 686 B1**
(45) Veröffentlichungstag und Bekanntmachung des Hinweises auf die Patenterteilung: **28.12.1994**
(21) Anmeldenummer: 89120144.4
(22) Anmeldetag: 30.10.1989
(51) Int. Cl.: H01L 27/02

(54) **Eingangsschutzstruktur für integrierte Schaltungen**
Input protection structure for integrated circuits
Structure de protection d'entrée pour circuits intégrés

(43) Veröffentlichungstag der Anmeldung: 05.06.1991
(73) Patentinhaber: SIEMENS AKTIENGESELLSCHAFT, 80333 München (DE)
(72) Erfinder: Becker, Burkhard, Dr. rer. nat., D-8000 München 80 (DE)

(56) Entgegenhaltungen:
- US-A- 4 486 770
- PATENT ABSTRACTS OF JAPAN vol. 5, no. 145 (E-74)(817) 12 September 1981 ; & JP-A-56 79 463
- PATENT ABSTRACTS OF JAPAN vol. 9, no. 193 (E-334)(1916) 09 August 1985 ; & JP-A-60 59 762
- PATENT ABSTRACTS OF JAPAN vol. 6, no. 103 (E-112)(981) 12 Juni 1982 ; & JP-A-57 34 361
- IBM TECHNICAL DISCLOSURE BULLETIN. vol. 20, no. 11B, April 1978, New York, US, Seite 4811 ; E. BERNDLMAIER : "FUNCTIONAL ELECTROSTATIC DISCHARGE PROTECT DEVICE".

## Beschreibung

Die vorliegende Erfindung betrifft eine Eingangsschutzstruktur für integrierte Schaltungen.

Integrierte Schaltungen benötigen einen sicheren Schutz gegen elektrostatische Entladungen. Sich auf derartige elektrostatische Entladungen beziehende Mechanismen sind im einzelnen in der DE-OS 36 16 394 erläutert. Aus dieser Druckschrift ist insbesondere eine Eingangsschutzstruktur für bipolare integrierte Schaltungen bekannt, die aus einem zwischen einem Eingang und einem Referenzpotential geschalteten npn-Transistor besteht, dessen Basis über einen Widerstand gekoppelt (kurzgeschlossen) ist und auf Referenzpotential - speziell Masse - liegt.

Die technische Realisierung einer solchen Schutzstruktur in einem Halbleitersubstrat sieht einen üblichen Bipolartransistor in einer epitaktischen Schicht an der Oberfläche des Halbleitersubstrats vor, wobei der Kollektor dieses Transistors in üblicher Weise durch die hochohmige epitaktische Schicht und Basis sowie Emitter durch zwei entsprechende Diffusionsgebiete in der epitaktischen Schicht gebildet sind. Bei der üblichen Ausgestaltung des Transistors können aufgrund der erhöhten Ladungsträgerdichte in der Nähe der Systemoberfläche Oberflächenfrühdurchbrüche auftreten, wodurch die ESD-Belastbarkeit der Schutzstruktur vermindert werden kann.

Eine weitere Eingangsschutzstruktur der in Rede stehenden Art ist in der europäischen Patentanmeldung EP-A-0 404 977 beschrieben. Diese ist jedoch auf die speziellen Anforderungen zugeschnitten, die bei einer großen Dicke der epitaktischen Schicht vorliegen, und nur bei bipolar integrierten Schaltungen mit einer Isolation benachbarter Bauelemente durch Diffusionsgebiete vorteilhaft zu realisieren.

Auch aus der Schrift "Patent Abstracts of Japan, Vol. 9, No. 193 (E-334) [1916], 9. August 1985 & JP-A-60 59762" ist eine Eingangsschutzstruktur bekannt, die einen Transistor und einen Widerstand besitzt, der extern mit der Basis und dem Emitter verbunden ist. Parallel zur Kollektor-Emitter-Strecke des Transistors ist eine Diode geschaltet, die durch den n-dotierten Kollektor und das p-dotierte Halbleitersubstrat gebildet ist. Allerdings sind dort der Transistor und der Widerstand in unterschiedlichen Wannen im Halbleitersubstrat ausgebildet.

Eine weitere Eingangsschutzstruktur mit einem Transistor und einem Widerstand ist aus der Schrift "Patent Abstracts of Japan, Vol. 5, No. 145 (E-74) [817], 12. September 1981 & JP-A-56 79463" bekannt, wobei auch dort der Kollektor-Emitter-Strecke eine Diode parallel geschaltet ist. Wie aus Figur 4 dieser Schrift hervorgeht, wird die Diode ebenfalls durch das Halbleitersubstrat und die Kollektorzone gebildet.

Die US-A-4 486 770 beschreibt eine Eingangsschutzstruktur mit einem Transistor und einem Widerstand. Dabei stellt der Widerstand jedoch ein mit der Basis zusammenhängendes dotiertes Gebiet dar. Eine externe Verbindung über eine Leitbahn ist nur mit dem Emitter, nicht jedoch mit der Basis vorgesehen. Ferner hängt die vergrabene hochdotierte Schicht 40 (buried collector) unter der Basis nur über eine schmale Stelle mit derjenigen unterhalb des Widerstandes zusammen.

Der vorliegenden Erfindung liegt daher die Aufgabe zugrunde, eine Eingangsschutzstruktur der in Rede stehenden Art anzugeben, die bei bipolaren integrierten Schaltungen mit einer Isolation benachbarter Bauelemente durch Oxidgebiete einen zuverlässigen Schutz bei einer einfachen Herstellungsweise gewährleistet.

Diese Aufgabe wird bei einer Eingangsschutzstruktur der eingangs genannten Art erfindungsgemäß durch die Merkmale des Patentanspruchs 1 gelöst. Weiterbildungen der Erfindung sind Gegenstand von Unteransprüchen.

Die Erfindung wird im folgenden anhand von Ausführungsbeispielen gemäß den Figuren 1 bis 3 der Zeichnung näher erläutert. Es zeigt:
- Figur 1: ein Ersatzschaltbild einer Eingangsschutzstruktur in Form eines Transistors mit einem Widerstand und zweier integrierter Dioden,
- Figur 2 und Figur 3: zwei Ausführungsformen der Realisierung einer Eingangsschutzstruktur nach Figur 1 in einem Halbleitersystem in schematischer Darstellung.

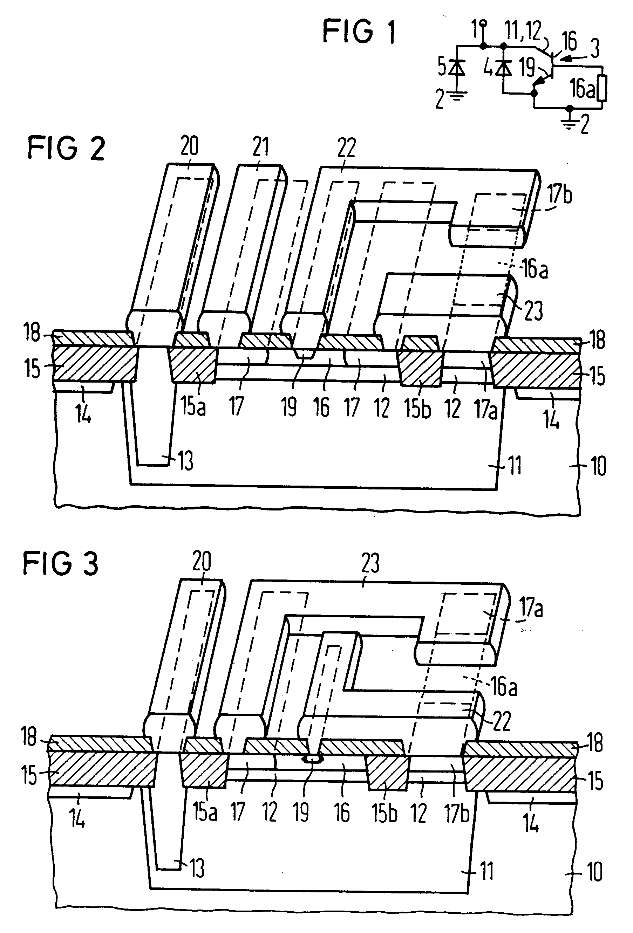

Figur 2 und Figur 3 zeigen dabei einen Schnitt durch die Mitte der Eingangsschutzstruktur mit zusätzlicher Schrägaufsicht nach hinten; die vollständige Eingangsschutzstruk tur erhält man durch symmetrische Fortsetzung nach vorne.

Gemäß Figur 1 liegt zwischen einem Eingang 1 einer integrierten Schaltung, insbesondere einer bipolaren integrierten Schaltung, und einem Referenzpotential 2, insbesondere Masse, eine Schutzstruktur, welche durch einen Transistor 3 mit der bereits erläuterten Kopplung zwischen Basis 16 und Emitter 19 über einen Widerstand 16a und mit einem Kollektor 11, 12 und durch zwei integrierte Dioden 4, 5 gebildet ist. Insbesondere ist dabei der Kollektor 11, 12 des Transistors 3 an den Eingang 1 und der Verbindungspunkt zwischen Emitter 19 und Widerstand 16a an das Bezugspotential 2 angeschlossen. Die beiden integrierten Dioden 4, 5 sind ebenfalls zwischen den Eingang 1 und das Referenzpotential 2 geschaltet, wobei die erste Diode 4 direkt parallel zur Emitter-Kollektor-Strecke des Transistors 3 geschaltet ist. Aufgrund der sich aus Figur 1 ergebenden Schaltungspolaritäten des Transistors 3 und der Dioden 4, 5 wirkt diese Schutzstruktur für elektrostatische Entladungen beider Polaritäten.

Die Bezugszeichen nach Figur 1, insbesondere für den Transistor 3 und dessen Beschaltung durch den Widerstand 16a sind in Übereinstimmung mit den Bezugszeichen nach Figur 2 des im folgenden zu erläuternden Halbleitersystems gewählt, in dem die Schutzstruktur gemäß eines ersten Ausführungsbeispiels realisiert ist. Die Schutzstruktur im Halbleitersystem nach Figur 2 wird im folgenden anhand der schematischen Verfahrensabfolge bei der Herstellung erläutert.

Ausgangspunkt für die Herstellung eines Halbleitersystems nach Figur 2 ist ein Halbleitersubstrat 10 eines ersten Leitungstyps, bei dem es sich vorzugsweise um den p-Leitungstyp handelt. In dieses Halbleitersystem wird in an sich konventioneller Weise, beispielsweise durch eine Implantation mit einem anschließenden Temperaturschritt, zunächst eine insbesondere hochdotierte Zone des entgegengesetzten zweiten Leitungstyps, im vorliegenden Beispiel also des n-Leitungstyps, eindiffundiert, durch die mit den nachfolgenden Herstellungsschritten eine Buried-Layer-Zone 11 gebildet wird. Um die Wirkungsweise eines später zu bildenden Isolationsrahmens um die Schutzstruktur herum zu verbessern, können bekanntlich sogenannte Channel-Stopper-Bereiche 14 außerhalb der Buried-Layer-Zone 11 hergestellt werden, die den ersten Leitungstyp aufweisen. Anschließend wird in üblicher Weise eine epitaktische Schicht 12 des zweiten Leitungstyps auf die gesamte Oberfläche aufgebracht.

Zur Isolation verschiedener Teile der Schutzstruktur untereinander einerseits und der gesamten Struktur von benachbarten Gebieten des Halbleitersystems andererseits wird nun vorzugsweise eine konventionelle LOCOS-Technik angewandt. Derartige Isolationstechniken sind in dem Buch von D. Widmann, H. Mahrer, H. Friedrich, Technologie hochintegrierter Schaltungen, Springer-Verlag 1988, Seite 67 bis 72, erläutert. Es wird eine geeignete Maske (nicht dargestellt) aufgebracht, mit deren Hilfe zunächst in die epitaktische Schicht 12 Vertiefungen von etwa der halben Schichtdicke der epitaktischen Schicht geätzt werden, anschließend werden diese Stellen lokal aufoxidiert. Bevorzugt werden dabei solche LOCOS-Techniken eingesetzt, die zu Oxidzonen 15, 15a, 15b mit ebener Oberfläche führen. Alternativ kann auch eine Grabenisolationstechnik, wie sie in derselben Literaturstelle auf Seite 78 beschrieben ist, eingesetzt werden, die dann ebenfalls zu Oxidzonen 15, 15a, 15b führt. Die Oxidzonen 15, 15a, 15b werden vorzugsweise so ausgebildet, daß sie mindestens die Dicke der epitaktischen Schicht 12 besitzen, so daß an den von ihnen bedeckten Stellen des Halbleitersystems die epitaktische Schicht 12 durch sie vollständig unterbrochen wird. Ist das nicht der Fall, sorgen die Channel-Stopper-Bereiche 14 für eine vollständige Isolation der Bauelemente untereinander. Die Oxidzonen 15 bilden auf diese Weise einen Teil eines noch zu vervollständigen Isolationsrahmens um die Eingangsschutzstruktur herum. Die Oxidzonen 15a, 15b reichen vorzugsweise durch die epitaktische Schicht 12 bis in die unterliegende Buried-Layer-Zone 11 hinein.

Für die niederohmige Kontaktierung der Buried-Layer-Zone 11 mit einem noch zu bildenden Anschluß wird eine hochdotierte Zone 13, die in diesem Beispiel den n-Leitungstyp aufweist, durch die epitaktische Schicht 12 in die Buried-Layer-Zone 11 eindiffundiert. Vorteilhafterweise wird diese Kontaktzone 13 so ausgebildet, daß sie seitlich durch die Oxidzonen 15, 15a begrenzt wird.

In die hier n-dotierte epitaktische Schicht 12 werden nun Zonen 16, 16a des ersten Leitungstyps, hier also mit p-Leitungstyp, eindiffundiert, die insbesondere schwach dotiert sind. An der Oberfläche des Halbleitersubstrats 10 bzw. der epitaktischen Schicht 12 sind die Zonen 16 und 16a mindestens durch die Oxidzone 15b voneinander isoliert. Aufgrund des hohen Schichtwiderstands der Zonen 16, 16a kann die Dotierung auch ganzflächig, d. h. ohne Einsatz einer Maske, erfolgen, ohne daß dabei die hochdotierte Kontaktzone 13 nennenswert verändert wird.

In die Zone 16 werden nun hochdotierte Teilzonen 17 und gleichzeitig in die Zone 16a hochdotierte Teilzonen 17a, 17b desselben Leitungstyps wie die Zonen 16 und 16a, im vorliegenden Fall also des p-Leitungstyps, eindiffundiert. Dabei dienen die Zonen 17 als Kontaktzonen für einen späteren Anschluß der Zone 16, und entsprechend die Zonen 17a, b als Kontaktzonen für die Zone 16a.

Nachfolgend wird in die Zone 16 eine Zone 19 des zweiten Leitungstyps, hier also des n-Leitungstyps, eindiffundiert, deren Tiefe so bemessen wird, daß sie von der epitaktischen Schicht 12 durch die schwach dotierte Zone 16 getrennt ist. Schließlich wird eine insbesondere aus Siliziumoxid bestehende Isolationsschicht 18, die entweder zu diesem Zeitpunkt auf die gesamte Oberfläche des Halbleitersystems aufgebracht wird oder bei den vorausgegangenen Temperaturschritten der Diffusionsprozesse bereits erzeugt worden ist, so strukturiert, daß die Kontaktzonen 13, 17, 17b, 17a und die Zone 19 anschließbar sind. Die erwähnten Zonen werden mit Leitbahnen 20, 21, 22, 23 als Anschlüsse versehen, wobei die Leitbahn 20 mit dem Eingang 1 und die Leitbahn 22 mit dem Referenzpotential 2 verbunden werden (nicht dargestellt). Die Leitbahn 22 verbindet die Zone 19 mit der Kontaktzone 17b, die Leitbahn 23 verbindet die Kontaktzonen 17 und 17a miteinander. Die Leitbahn 21 dient lediglich der Homogenisierung des Potentialverlaufs in den Zonen 16, 17 und wird nicht nach außen kontaktiert.

Die oberhalb der Oxidzonen 15 befindlichen Teile der Isolationsschicht 18 vervollständigen den bereits erwähnten Isolationsrahmen 15, 18 um die Eingangsschutzstruktur herum.

Aufgrund der erläuterten Zonenstruktur wird im Halbleitersystem nach Figur 2 ein npn-Transistor 3 gemäß Figur 1 gebildet durch die Buried-Layer-Zone 11 mit der epitaktischen Schicht 12 als Kollektor, die Zone 16 als Basis, und die Zone 19 als Emitter, wobei die Zone 13 die Kollektor-Kontaktzone und die Zonen 17 die Basis-Kontaktzonen bilden. Über die Leitbahn 20 als Kollektor-Anschluß wird der Transistor mit seinem Kollektor 11, 12 an den Eingang 1 und über die Leitbahn 22 als Emitter-Anschluß mit seinem Emitter 19 an das Referenzpotential geschaltet.

Erfindungsgemäß wird der Widerstand 16a durch die schwach dotierte Zone 16a realisiert. Er ist über die Kontaktzone 17a und die als Basis-Anschluß wirkende Leitbahn 23 an die Basis-Kontaktzone 17 und damit an die Basis angeschlossen, sowie über die Kontaktzone 17b und den Emitter-Anschluß 22 an den Emitter 19. Von diesen Leitbahnen 22, 23 abgesehen ist der Widerstand 16a durch die Oxidzonen 15, 15b und Teile der Isolationsschicht 18 von der Basis 16 und dem Emitter 19 isoliert; mittels des unter der Diffusionszone 16a liegenden Teils der epitaktischen Schicht 12 bildet er mit der Buried-Layer-Zone 11 eine noch genauer zu erläuternde integrierte Diode gemäß der Diode 4 in Figur 1.

Wie bereits angegeben, ist die Eingangsschutzstruktur nach Figur 2 durch Spiegelung an der dargestellten Schnittlinie nach vorne hin zu vervollständigen. Daher weist die komplette Eingangsschutzstruktur einen zum Widerstand 16a parallel geschalteten weiteren Widerstand auf, d. h., der in Figur 1 dargestellte Widerstand 16a wird im Halbleitersystem durch zwei parallel geschaltete Widerstände realisiert. Dies ist im Hinblick auf die noch zu erläuternden elektrischen Eigenschaften der Eingangsschutzstruktur besonders vorteilhaft.

Die erste integrierte Diode 4 in Figur 1 wird im Halbleitersystem nach Figur 2 durch die Zone 16a und den unterliegenden Teil der epitaktischen Schicht 12 einschließlich der Buried-Layer-Zone 11 gebildet. Diese erste Diode 4 ist somit parallel zum Widerstand 16a und zum Kollektor-Basis-Übergang bzw. parallel zur Emitter-Kollektor-Strecke des Transistors geschaltet und in einem vom Transistor-Bereich im wesentlichen getrennten Teil der epitaktischen Schicht 12 angeordnet. Die zweite integrierte Diode 5 wird durch das Halbleitersubstrat 10 und die Buried-Layer-Zone 11 gebildet, wobei das Halbleitersubstrat 10 an das Referenzpotential 2 anzuschließen ist (nicht dargestellt).

Figur 3 zeigt eine weitere Ausführungsform der Erfindung, wobei die Bezugsziffern in Übereinstimmung mit Figur 2 gewählt sind. Ersichtlich unterscheidet sich diese zweite Ausführungsform von der ersten durch den Wegfall einer der beiden Basis-Kontakt-Zonen 17 und die Anordnung des Emitter-Anschlusses 22, der den Widerstand 16a mit dem Emitter 19 verbindet, und des Basis-Anschlusses 23, der den Widerstand 16a mit der Basis-Kontaktzone 17 und damit der Basis 16 verbindet. Der übrige Aufbau und der Verfahrensablauf zur Herstellung der Schutzstruktur nach Figur 3 stimmt mit der Schutzstruktur nach Figur 2 überein. Insbesondere entspricht auch diese zweite Ausführungsform der Eingangsschutzstruktur dem Ersatzschaltbild nach Figur 1.

Ein negativer Spannungsimpuls am Eingang 1 wird zum Teil durch die in Durchlaß geschaltete zweite Schutzdiode 5 abgeführt. Ein anderer Teil fließt über den Emitter-Anschluß 22, der gleichzeitig den Masseanschluß der ersten Schutzdiode 4 darstellt, zum Referenzpotential 2 ab. Die erste Diode 4 ist in Flußrichtung gepolt. Die Schutzstruktur arbeitet hier im inversen Transistorbetrieb, wobei der empfindliche Basis-Emitter-Übergang in Sperrichtung gepolt ist. Der Anschluß der ersten Diode 4 in einem separaten Teil der epitaktischen Schicht 12, im wesentlichen getrennt vom Emitter-Basis-Bereich des Transistors 3 durch die Oxidisolation 15b, sorgt für eine Homogenisierung des Feldstärke-und Stromverlaufs und schützt so den empfindlichen Seitenbereichs dieses Übergangs.

Ein positiver Spannungsimpuls schaltet den Kollektor-Basis-Übergang in Sperrichtung sowie den Basis-Emitter-Übergang in Durchlaßrichtung. Ein U_{CEO}-Durchbruch wäre die Folge. Über den Widerstand 16a kann jedoch ein Stromfluß aus der Basis 16 erfolgen, wobei die Schutzstruktur in die normale Transistorarbeitsweise übergeht. Der U_{CEO}-Durchbruch geht durch den Widerstand 16a in einen U_{CER}-Durchbruch über. Die zwischen Emitter 19 und Kollektor 11,12 geschaltete erste integrierte Diode 4 in einem separaten Teil der epitaktischen Schicht 12 macht sich hier ebenfalls positiv bemerkbar. Sowohl der Kollektor-Basis-Übergang des npn-Transistors 3 als auch die erste Diode 4 sind in Sperrichtung gepolt. Der positive Eingangsimpuls baut sich an beiden Sperrschichten auf, wobei eine zu starke Belastung des dem Kollektor-Anschluß 20 gegenüberliegenden Seitenbereich des Kollektor-Basis-Übergangs vermieden wird und eine gleichmäßigere Feldstärke-Verteilung erreicht wird. Die Schutzstruktur leitet den Spannungsimpuls auf Grund ihrer kurzen Durchschaltzeit ab, bevor parallel liegende Baueelemente zerstört werden können. Die Polung des empfindlichen Basis-Emitter-Übergangs in Durchflußrichtung garantiert zudem eine hohe Belastbarkeit des Bauelements.

Durch die Anordnung der Anschlüsse und Kontaktzonen für Kollektor, Basis und Emitter wird einer zu großen Erhöhung der Stromdichte an dem dem Kollektor-Anschluß 20 gegenüberliegenden Seitenbereich des Emitter-Basis-Überganges entgegengewirkt. Dieser Vorteil kommt insbesondere bei der ersten Ausführungsform gemäß Figur 2 zum Tragen. Die zweite Ausführungsform gemäß Figur 3 bietet dagegen den Vorteil eines deutlich geringeren Platzbedarfs.

Der Vorteil der vorgestellten Schutzstruktur liegt in der Verwendungsmöglichkeit für hohe Signalspannungen des integrierten Schaltkreises. Der Durchbruch wird bestimmt durch die U_{CER}-Spannung, welche bekanntlich größer ist als die U_{CEO}-Spannung.

## Patentansprüche

1. Eingangsschutzstruktur für bipolare integrierte Schaltungen, welche
- zwischen einem Eingang (1) und einem Referenzpotential (2) angeordnet ist, und
- mindestens einen Transistor (3) mit einem Widerstand (16a) aufweist,
-- dessen Kollektor (11) mit dem Eingang (1) verbunden ist und dessen Basis (16) über den Widerstand (16a) und gemeinsam mit seinem Emitter (19) an das Referenzpotential (2) angeschlossen ist,
-- wobei der Kollektor (11) in einem Halbleitersubstrat (10) eines ersten Leitungstyps als vergrabener Kollektor mittels einer Zone eines zweiten Leitungstyps ausgebildet ist,
-- wobei die Basis (16) von mindestens einer dotierten Zone des ersten Leitungstyps in einer auf dem Halbleitersubstrat (10) über und in Kontakt mit dem vergrabenen Kollektor (11) aufgebrachten epitaktischen Schicht (12) des zweiten Leitungstyps gebildet ist, und mit einem als Leitbahn ausgebildeten Basisanschluß (23) versehen ist,
-- wobei der Kollektor (11) über einen durch die epitaktische Schicht (12) reichende Kontaktzone (13) des zweiten Leitungstyps mit einem als Leitbahn ausgebildeten Kollektoranschluß (20) versehen ist,
-- wobei ferner der Emitter (19) von einer dotierten Zone des zweiten Leitungstyps in der Basiszone (16) gebildet ist und mit einem als Leitbahn ausgebildeten Emitteranschluß (22) versehen ist, und
-- wobei der Widerstand (16a) von mindestens einer weiteren schwach dotierten Zone (16a) des ersten Leitungstyps in der epitaktischen Schicht (12) gebildet ist, die an ihrem einen Ende mit dem Emitter (19) nur über den Emitteranschluß (22) und an ihrem anderen Ende mit der Basis (16) nur über den Basisanschluß (23) verbunden ist und von der oder den Basiszone(n) (16, 17) durch eine Oxidzone (15b), die mindestens die Dicke der epitaktischen Schicht (12) besitzt, isoliert ist,
- und eine erste integrierte Diode (4), welche durch die weitere, schwach dotierte Zone (16a) des ersten Leitungstyps und den ihr unterliegenden Teil der epitaktischen Schicht (12) einschließlich eines Teils des vergrabenen Kollektors (11) gebildet ist, sowie eine zweite integrierte Diode (5), welche durch das mit dem Referenzpotential verbundene Halbleitersubstrat (10) und den vergrabenen Kollektor (11) gebildet ist, aufweist.

2. Eingangsschutzstruktur nach Anspruch 1, bei der der Widerstand (16a) aus zwei parallel geschalteten Widerständen mit im wesentlichen gleichen Widerstandswerten zusammengesetzt ist, wobei die beiden parallel geschalteten Widerstände durch die weitere schwach dotierte Zone und eine zusätzliche schwach dotierte Zone des ersten Leitungstyps symmetrisch zueinander gebildet sind.

3. Eingangsschutzstruktur nach einem der Ansprüche 1 bis 2, bei der die Basis (16) aus einer schwach dotierten Zone (16) mit mindestens einer hochdotierten Teilzone (17) als Basis-Kontaktzone besteht.

4. Eingangsschutzstruktur nach Anspruch 3, bei der die den Widerstand (16a) bildende schwach dotierte Zone an ihren Enden zwei, gleichzeitig mit den Basis-Kontaktzonen (17) hergestellte hochdotierte Teilzonen (17a, 17b) als Kontaktzonen aufweist und über eine dieser Teilzonen (17a) an den Basisanschluß (23) und über die andere Teilzone (17b) an den Emitteranschluß (22) angeschlossen ist.

## Claims

1. Input protection structure for bipolar integrated circuits, which
- is disposed between an input (1) and a reference potential (2), and
- has at least one transistor (3) with a resistor (16a),
-- whose collector (11) is connected to the input (1) and whose base (16) is connected via the resistor (16a) and jointly with its emitter (19) to the reference potential (2),
-- the collector (11) being formed in a semiconductor substrate (10) of a first conduction type as a buried collector by means of a zone of a second conduction type,
-- the base (16) being formed by at least one doped zone of the first conduction type in an epitaxial layer (12) of the second conduction type applied to the semiconductor substrate (10) above and in contact with the buried collector (11) and being provided with a base terminal (23) formed as a conductor track,
-- the collector (11) being provided with a collector terminal (20) formed as a conductor track by means of a contact zone (13) of the second conduction type which extends through the epitaxial layer (12),
-- the emitter (19) furthermore being formed by a doped zone of the second conduction type in the base zone (16) and being provided with an emitter terminal (22) formed as a conductor track, and
-- the resistor (16a) being formed by at least one further lightly doped zone (16a) of the first conduction type in the epitaxial layer (12), which layer is connected at one end to the emitter (19) only via the emitter terminal (22) and at the other end to the base (16) only via the base terminal (23) and being isolated from the base zone or zones (16, 17) by an oxide zone (15b) which is at least as thick as the epitaxial layer (12),
- and has a first integrated diode (4) which is formed by the further lightly doped zone (16a) of the first conduction type and the part situated underneath it of the epitaxial layer (12), including a part of the buried collector (11), and it also has a second integrated diode (5) which is formed by the semiconductor substrate (10) connected to the reference potential and the buried collector (11).

2. Input protection structure according to Claim 1, in which the resistor (16a) is made up of two parallel-connected resistors having essentially equal resistance values, the two parallel-connected resistors being formed by the further lightly doped zone and an additional lightly doped zone of the first conduction type in a symmetrical manner with respect to one another.

3. Input protection structure according to one of Claims 1 or 2, in which the base (16) comprises a lightly doped zone (16) having at least one heavily doped subzone (17) as base contact zone.

4. Input protection structure according to Claim 3, in which the lightly doped zone forming the resistor (16a) has, at its ends, two heavily doped subzones (17a, 17b), produced simultaneously with the base contact zones (17) as contact zones and is connected via one of said subzones (17a) to the base terminal (23) and via the other subzone (17b) to the emitter terminal (22).

## Revendications

1. Structure de protection d'entrée pour des circuits intégrés bipolaires, qui
- est disposée entre une entrée (1) et un potentiel de référence (2), et
- comporte au moins un transistor (3) pourvu d'une résistance (16a) et
-- dont le collecteur (11) est relié à l'entrée (1) et dont la base (16) est raccordée au potentiel de référence (2) par l'intermédiaire de la résistance (16a) et ce conjointement avec son émetteur (19),
-- le collecteur (11) étant réalisé dans un substrat semiconducteur (10) possédant un premier type de conductivité, en tant que collecteur enseveli, au moyen d'une zone possédant un second type de conductivité,
-- la base (16) étant formée par au moins une zone dopée possédant un premier type de conductivité dans une couche épitaxiale (12) possédant le second type de conductivité, qui est disposée sur le substrat semiconducteur (10) au-dessus de et en contact avec le collecteur enseveli (11), et étant équipée d'une borne de base (23) réalisée sous la forme d'une voie conductrice,
-- le collecteur (11) comportant, au-dessus d'une zone de contact (13) possédant le second type de conductivité et qui s'étend à travers la couche épitaxiale (12), une borne de collecteur (20) réalisée sous la forme d'une voie conductrice,
-- l'émetteur (19) étant en outre formé par une zone dopée possédant le second type de conductivité dans la zone de base (16) et étant équipé d'une borne d'émetteur (22) réalisée sous la forme d'une voie conductrice, et
-- la résistance (16a) étant formée par au moins une autre zone faiblement dopée (16a) possédant le premier type de conductivité dans la couche épitaxiale (12), qui est reliée, par l'une de ses extrémités, à l'émetteur (19) uniquement par l'intermédiaire de la borne d'émetteur (22) et, au niveau de son autre extrémité, à la borne de base (16) uniquement par l'intermédiaire de la borne de base (23), et étant isolée de la ou des zones de base (16,17) par une zone d'oxyde (15b), qui possède au moins l'épaisseur de la couche épitaxiale (12), et
- une première diode intégrée (4), qui est formée par l'autre zone faiblement dopée (16a) possédant le premier type de conductivité et par la partie, qui est située au-dessous de cette zone, de la couche épitaxiale (12) y compris une partie du collecteur enseveli (11), ainsi qu'une seconde diode intégrée (5), qui est formée par le substrat semiconducteur (10), qui est relié au potentiel de référence, et par le collecteur enseveli (11).

2. Structure de protection suivant la revendication 1, dans laquelle la résistance (16a) est constituée par la réunion de deux résistances branchées en parallèle et possédant des valeurs résistives sensiblement identiques, les deux résistances branchées en parallèle étant formées d'une manière symétrique l'une de l'autre au moyen de l'autre zone faiblement dopée et d'une zone supplémentaire faiblement dopée possédant le premier type de conductivité.

3. Structure de protection suivant l'une des revendications 1 et 2, dans laquelle la base (16) est constituée par une zone faiblement dopée (16) possédant au moins une zone partielle fortement dopée (17) en tant que zone de contact de base.

4. Structure de protection suivant la revendication 3, dans laquelle la zone faiblement dopée, qui constitue la résistance (16a), comporte, au niveau de ses extrémités, deux zones partielles fortement dopées (17a,17b), en tant que zones de contact, réalisées en même temps que les zones de contact de base (17), et est raccordée à la borne de base (23) par l'intermédiaire de l'une de ses zones partielles (17a) et à la borne d'émetteur (22) par l'intermédiaire de l'autre zone partielle (17b).
